# EUROPÄISCHE PATENTSCHRIFT

(11) **EP 3 882 983 B1**
(45) Veröffentlichungstag und Bekanntmachung des Hinweises auf die Patenterteilung: **24.09.2025**
(21) Anmeldenummer: 21000073.3
(22) Anmeldetag: 12.03.2021
(51) Int. Cl.: H10D 8/01, H10D 8/00, H10D 62/10, H10D 62/824, H10D 62/85, H10D 62/852, H10F 30/29, H10F 39/00, H10F 39/18, H10F 71/00, H10F 77/124, H10F 77/14, H10F 77/20, H10F 77/30

(54) **STAPELFÖRMIGES PHOTONISCHES III-V-HALBLEITERBAUELEMENT**
STACKED PHOTONIC III-V SEMICONDUCTOR MODULE
COMPOSANT PHOTONIQUE EMPILÉ À SEMI-CONDUCTEUR III-V

(30) Priorität: 20.03.2020 DE 102020001837
(43) Veröffentlichungstag der Anmeldung: 22.09.2021
(73) Patentinhaber: AZUR SPACE Solar Power GmbH, 74072 Heilbronn (DE)
(72) Erfinder: Fuhrmann, Daniel, 74081 Heilbronn (DE); Keller, Gregor, 74080 Heilbronn (DE); Strobl, Gerhard, 70439 Stuttgart (DE); Wächter, Clemens, 74348 Lauffen am Neckar (DE)
(74) Vertreter: Koch Müller Patentanwaltsgesellschaft mbH

(56) Entgegenhaltungen:
- US-A- 5 712 504
- US-A1- 2007 278 626
- US-A1- 2010 213 513
- US-A1- 2016 020 339
- LEZHNEVA G M ET AL: "GaAs Pixel-Detector Technology for X-ray Medical Imaging: A Review", RUSSIAN MICROELECTRONICS, NAUKA/INTERPERIODICA, MO, vol. 34, no. 4, 1 July 2005 (2005-07-01), pages 229 - 241, XP019302363, ISSN: 1608-3415
- LEE G S ET AL: "Characterization of molecular beam epitaxially grown InSb layers and diode structures", SOLID STATE ELECTRONICS, ELSEVIER SCIENCE PUBLISHERS, BARKING, GB, vol. 36, no. 3, 1 March 1993 (1993-03-01), pages 387 - 389, XP025785842, ISSN: 0038-1101, [retrieved on 19930301], DOI: 10.1016/0038-1101(93)90091-4

## Beschreibung

Die Erfindung betrifft ein stapelförmiges photonisches III-V-Halbleiterbauelement.

III-V-Halbleiterdioden werden inzwischen mit jeweils angepassten Parametern in den verschiedensten Bereichen eingesetzt.

Aus "GaAs Power Devices" von German Ashkinazi, ISBN 965-7094-19-4, Seite 8 und 9 ist eine hochspannungsfeste Halbleiterdiode mit p⁺ - n - n⁺ Struktur bekannt.

Weitere hochspannungsfeste III-V-Halbleiterdioden und entsprechende Herstellungsverfahren sind auch aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Aus der US 2007/278 626 A1; der US 5 712 504 A; Lezhneva et al "GaAs Pixel-Detector Technology for X-ray Medical Imaging: A Review", RUSSIAN MICROELECTRONICS, NAUKA/INTERPERIODICA, Bd. 34, Nr. 4, 01.07.2005, S. 229-241, XP019302363, ISBN: 1608-3415; der US 2010/213 513 A1; der US 2016/020 339 A1 und aus Lee et al: "Characterization of molecular beam epitaxially grown InSb layers and diode structures", SOLID STATE ELECTRONICS, ELSEVIER SCIENCE PUBLISHERS, BARKING, GB, Bd. 36, Nr. 3, 01.03.1993, S. 387-389, XP025785842, ISSN: 0038-1101 sind weitere III-V Bauelemente bekannt.

III-V-Halbleiterdioden werden als Pixel in 2D-Pixel-Array-Detektoren eingesetzt.

Beispielsweise sind Infrarotdetektoren aus "InGaAs NIR focal plane arrays for imaging and DWDM applications", Barton et al., Infrared Detectors and Focal Plane Arrays VII, Proc. Of SPIE Vol. 4721, 2002, bekannt. Die beschriebenen III-V-Halbleiterdiodenstrukturen weisen jeweils ein gitterangepasstes InGaAs Absorptionsgebiet auf einem n+ InP Substrat, ein durch Diffusion erzeugtes p+ Kontaktgebiet und eine InP Passivierungsschicht auf.

Entsprechende Infrarotdetektoren sind auch aus "Multiplexed 256 Element InGaAs Detector Arrays for 0.8 - 1.7 um Room-Temperature Operation", Olsen et al., Infrared Technology XIV, SPIE Vol. 972, 279 und aus "InGaAs focal plane arrays developments at III-VLab", Rouvie et al., Infrared Technology and Applications XXXVIII, Proc. Of SPIE Vol. 8358, 835308, 2012, doi: 10.1117/12.921134 bekannt.

Auch aus "FPA Development from InGaAs InSb to HgCdTe", Yuan et al., Infrared Technology and Applications XXXIV, Proc. of SPIE Vol. 6940, 69403C, 2008, doi: 10.1117/12.782735 ist ein Infrarotdetektor bekannt, wobei verschiedene p-i-n Strukturen mit InGaAs mit unterschiedlichem Indium-Gehalt als Absorptionsgebiet auf einem InP Substrat gegebenenfalls mit einer Pufferschicht, sowie Pixel-Arrays auf Basis von InSb und HgCdTe beschrieben werden.

Aus "A Method for Adjusting the Performance of Epitaxial GaAs X-ray Detectors", Sun,G.C. and Bourgoin,J.C., Nucl. Instrum. Methods Phys. Res., Sect. A, 2003, vol. 512, pp. 355-360, aus "GaAs Schottky versus p/i/n Diodes for Pixellated X-ray Detectors", Bourgoin,J.C. and Sun,G.C., Nucl. Instrum. Methods Phys. Res., Sect. A, 2002, vol. 487, pp. 47-49, ebenso aus der DE 602 21 638 T2, ist ein Verfahren und Gerät zur Herstellung eines GaAs-Detektors für eine Röntgenstrahl-Erfassung und eine Bildaufnahme bekannt. Des Weiteren ist aus der WO 2004 816 04 A2 eine weitere GaAs-Bildaufnahmevorrichtung zur Detektion von Röntgenstrahlung bekannt.

Als Pixel eines Röntgendetektors sind p-i-n Strukturen aus GaAs aus "GaAs Pixel-Detector Technology for X-ray Medical Imaging", Lezhneva et al., Russian Microelectronics, Vol. 34, No. 4, 2005, pp. 229-241, bekannt, wobei sowohl epitaktisch gewachsene als auch implantierte p+ Kontaktgebiet offenbart werden. Alternativ werden GaAs basierte Schottky Dioden offenbart.

Ein ebenfalls auf Schottky-Dioden basierender Röntgendetektor auf GaAs-Basis ist aus "GaAs X-Ray System Detectors for Medical Applications", Rizzi et al., https://www.researchgate.net/publication/237780321, bekannt.

Nachteilig an den beschriebenen Strukturen sind die Rest- bzw. Leckströme, die bei einem Betrieb in Sperrrichtung, insbesondere über die Ränder der planaren p-n Übergänge bzw. der Mesa-Strukturen auftreten.

Vor diesem Hintergrund besteht die Aufgabe der Erfindung darin, eine Vorrichtung anzugeben, die den Stand der Technik weiterbildet.

Die Aufgabe wird durch ein photonisches III-V-Halbleiterbauelement mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein stapelförmiges photonisches III-V-Halbleiterbauelement bereitgestellt.

Das stapelförmige photonische III-V-Halbleiterbauelement weist eine zumindest gebietsweise ausgebildete erste metallische Anschlusskontaktschicht sowie eine zumindest gebietsweise ausgebildete zweite metallische Anschlusskontaktschicht auf.

Außerdem weist das III-V-Halbleiterbauelement eine erste hochdotierte Halbleiterkontaktschicht eines ersten Leitfähigkeitstyps mit einer Dotierstoffkonzentration von mindestens 1•10¹⁸ cm⁻³ oder von mindestens 5•10¹⁸ cm⁻³ und mit einer ersten Gitterkonstanten auf.

Weiterhin weist das photonische III-V-Halbleiterbauelement ein Absorptionsgebiet eines zweiten Leitfähigkeitstyps mit der ersten Gitterkonstanten, mit einer ersten Energiebandlücke, mit einer Schichtdicke in einem Bereich zwischen 80 µm und 2000 µm und mit einer Dotierstoffkonzentration von 8•10¹¹ - 8•10¹⁴ cm⁻³ auf. Vorzugsweise weist das Absorptionsgebiet eine gleichmäßige Dotierstoffkonzentration über die gesamte Dicke des Absorptionsgebiets auf.

In einer anderen Ausführungsform variiert die Höhe der Dotierstoffkonzentration über die Dicke des Absorptionsgebietes.

Die erste Halbleiterkontaktschicht ist als Mesa-Struktur mit einer Unterseite, einer Oberseite, einer Mesa-Breite und einer Mesa-Höhe ausgebildet.

Die Unterseite der ersten Halbleiterkontaktschicht ist auf oder oberhalb eines ersten Oberflächenabschnitts der Oberseite des Absorptionsgebiets mit einer mit der Mesa-Breite übereinstimmenden Breite angeordnet.

Die Unterseite der ersten metallischen Anschlusskontaktschicht ist stoffschlüssig mit der Oberseite der ersten Halbleiterkontaktschicht verbunden.

Die zweite metallische Anschlusskontaktschicht ist unterhalb einer Unterseite des Absorptionsgebiets angeordnet.

Das stapelförmige photonische III-V-Halbleiterbauelement weist außerdem eine III-V-Halbleiterpassivierungsschicht mit der ersten Gitterkonstanten und einer sich von der ersten Energiebandlücke unterscheidenden zweiten Energiebandlücke auf.

In einer ersten Ausführungsform ist die zweite Energiebandlücke der III-V-Halbleiterpassivierungsschicht größer als die erste Energiebandlücke des Absorptionsgebiets.

Die III-V-Halbleiterpassivierungsschicht weist hierbei den ersten oder den zweiten Leitfähigkeitstyp auf, d.h. die III-V-Halbleiterpassivierungsschicht und das Absorptionsgebiet weisen den gleichen Leitfähigkeitstyp auf oder die III-V-Halbleiterpassivierungsschicht weist einen von dem Leitfähigkeitstyp des Absorptionsgebiets abweichenden Leitfähigkeitstyp auf.

Die III-V-Halbleiterpassivierungsschicht weist eine Dotierstoffkonzentration in einem Bereich zwischen 1•10¹⁴ cm⁻³ und 5•10¹⁸ cm⁻³ auf.

Die III-V-Halbleiterpassivierungsschicht ist in einem ersten Abstand von mindestens 0,2 µm oder von mindestens 2 µm oder von mindestens 10 µm oder von mindestens 20 µm oder von mindestens 40 µm und vorzugsweise maximal 500 µm oder vorzugsweise maximal 100 µm oder vorzugsweise maximal 50 µm zu der Mesa-Struktur der ersten Halbleiterkontaktschicht auf der Oberseite des Absorptionsgebiets angeordnet und mit der Oberseite des Absorptionsgebiets stoffschlüssig verbunden.

Es wird angemerkt, dass es sich auch bei dem Absorptionsgebiet um eine Halbleiterschicht handelt.

Es versteht sich, dass das photonische III-V-Halbleiterbauelement mit einer n-auf-p oder einer p-auf-n Struktur ausgebildet sein kann. Entsprechend ist entweder der erste Leitfähigkeitstyp n und der zweite Leitfähigkeitstyp p oder vice versa.

Es sei auch angemerkt, dass die metallischen Anschlusskontaktschichten jeweils elektrisch sehr gut leitfähig sind. Bevorzugt bestehen die metallischen Anschlusskontaktschichten aus einer oder mehreren Metallschichten, wobei die Metallschichten bevorzugt Ge und/oder Au und/oder Ag und/oder Pd umfassen.

Die metallischen Anschlusskontaktschichten stellen zu der hochdotierten erste Halbleiterkontaktschicht sowie zu einer weiteren gegebenenfalls sehr schwach dotierten Halbleiterschicht, z.B. dem Absorptionsgebiet oder auch einer zweiten hochdotierten Halbleiterkontaktschicht, einen elektrisch niederohmigen Kontakt her.

Es versteht sich auch, dass die jeweilige Halbleiterschicht hierfür jeweils unmittelbar an die entsprechende metallische Anschlusskontaktschicht angrenzt.

Des Weiteren versteht es sich, dass die Anschlusskontaktschichten mittels Bonddrähte mit Kontaktfingern, den sogenannten Pins, und / oder mittels Kontaktpunkten, sogenannten Bumps, mit Flip-Chip-Montage verschaltet sind, indem das photonische Bauelemente oder auch mehrere photonische Bauelemente auf einem Träger beispielsweise in Form eines Leadframes angeordnet sind.

Alle Halbleiterschichten, also insbesondere das Absorptionsgebiet, die erste Halbleiterkontaktschicht und die III-V-Halbleiterpassivierungsschicht des photonischen III-V-Halbleiterbauelements sind bevorzugt epitaktisch erzeugt.

Das Absorptionsgebiet und die erste Halbleiterkontaktschicht bestehen beispielsweise aus GaAs oder umfassen beispielsweise GaAs und werden beispielsweise nacheinander auf einem GaAs-Substrat oder auf einem Ge-Substrat, z.B. mit einer InGaAs-Pufferschicht zum Ausgleichen des Gitterkonstantenunterschieds zwischen Germanium und Galliumarsenid, aufgewachsen.

Das Aufwachssubstrat, also z.B. das GaAs-Substrat oder das Ge-Substrat mit der InGaAs-Schicht, wird anschließend durch Schleifen und / oder Ätzen und / oder andere Prozesse, z.B. Ablösen, teilweise oder vollständig entfernt.

In einer Ausführungsform wird hierfür während eines Herstellungsprozesses des stapelförmigen III-V-Halbleiterbauelements eine Ätzstoppschicht unterhalb des Absorptionsgebiets eingefügt.

Die Ätzstoppschicht wird beispielsweise zwischen dem Absorptionsgebiet und einer Pufferschicht oder einer Substratschicht oder zwischen einer zweiten Halbleiterkontaktschicht und einer Pufferschicht oder einer Substratschicht oder zwischen einer Pufferschicht und einer Substratschicht erzeugt.

Die Ätzstoppschicht ermöglicht ein nachfolgendes Ablösen der Substratschicht und der Pufferschicht oder nur der Substratschicht mittels eines Ätzprozesses, z.B. nasschemisches Ätzen. Insbesondere ermöglicht es die Ätzstoppschicht, Substrat und/oder Pufferschicht ohne eine mechanischen Schleifprozess zu entfernen.

Die Ätzstoppschicht selbst kann danach auch entfernt werden. Die Ätzstoppschicht weist eine starke chemische Anisotropie gegenüber den angrenzenden Schichten auf, das heißt die Ätzrate für die Ätzstoppschicht und die anschließende Schicht unterscheiden sich mindestens um einen Faktor 10.

Die Ätzstoppschicht besteht üblicherweise aus GaInP oder AlGaAs und die umgebenden Schichten aus GaAs oder GaInAs. Die entfernten Schichten sind in dem finalen Bauelement nicht mehr vorhanden.

In einer weiteren Ausführungsform wird auf einem Ge-Substrat eine InGaAs- oder InGaP-Zwischenschicht zum Ausgleich eines Gitterkonstantenunterschieds zu folgenden GaAs-Schichten des III-V-Bauelements aufgewachsen, wobei die Zwischenschicht gleichzeitig als Ätzstoppschicht dient. Anschließend werden die Halbleiterschichten des Bauelements, bevorzugt aus GaAs, epitaktisch erzeugt. Später wird erst das Ge-Substrat mittels eines Ätzprozesses entfernt und danach mittels eines weiteren Ätzprozesses, z.B. nasschemisches Ätzen, die InGaP- oder InGaAs-Zwischenschicht von dem photonischen GaAs-Bauelement entfernt.

Alternativ zu dem vollständigen Entfernen des Aufwachssubstrats wird das Aufwachssubstrat, z.B. ein mit dem zweiten Leitfähigkeitstyp dotiertes GaAs-Substrat, nur teilweise entfernt, so dass eine verbleibende dünne Schicht eine hochdotierte zweite Halbleiterkontaktschicht des zweiten Leitfähigkeitstyps ausbildet.

Die Mesa-Struktur der ersten Halbleiterkontaktschicht ist bevorzugt durch zwei Ätzschritte und einen zweiten Epitaxieprozess erzeugt.

Bevorzugt erzeugt ein erster Ätzschritt eine durch die epitaktisch erzeugte flächige III-V-Halbleiterpassivierungsschicht bis zu dem Absorptionsgebiet reichende Lücke, anders ausgedrückt die III-V-Halbleiterpassivierungsschicht ist im Bereich der Lücke weggeätzt.

Anschließend werden der Mesa-Struktur entsprechende Schichten aufgewachsen und mittels des zweiten Ätzschritts die Mesa-Struktur freilegt.

Die erste metallische Anschlusskontaktschicht wird entweder vor oder nach dem zweiten Ätzschritt auf die Oberseite der Mesa-Struktur aufgebracht .

Es versteht sich, dass insbesondere durch den zweiten Ätzschritt Gräben in einem die Mesa-Struktur umgebenden Bereich des Absorptionsgebiets entstehen, da gemäß bevorzugter Ausführungsformen keine oder nur eine sehr geringe Ätz-Selektivität zwischen dem Material der Mesa-Struktur und dem Material des Absorptionsgebiets besteht.

Alternativ wird zuerst eine der Mesa-Struktur entsprechende flächige Schicht auf dem Absorptionsgebiet aufgewachsen und die Mesa-Struktur durch Entfernen eines Teils dieser Schicht mittels eines ersten Ätzschritts freigelegt. Anschließend wird die III-V-Halbleiterpassivierungsschicht aufgewachsen und mittels eines zweiten Ätzschritts in einem Bereich auf und um die Mesa-Struktur wieder entfernt.

Es versteht sich, dass aufgrund der gegebenenfalls hohen Ätz-Selektivität der III-V-Halbleiterpassivierungsschicht die Oberseite des Absorptionsgebiets zwischen der Mesa-Struktur und unterhalb der III-V-Halbleiterpassivierungsschicht keinen Niveauunterschied, also keinen Graben aufweist.

Alternativ oder ergänzend sind eine oder mehrere Schichten des photonischen III-V-Halbleiterbauelements mittels eines Wafer-Bonds miteinander verbunden.

Es versteht sich auch, dass zumindest die mindestens eine Halbleiterkontaktschicht, das als Halbleiterschicht ausgebildete Absorptionsgebiet und die III-V-Halbleiterpassivierungsschicht des photonischen III-V-Bauelements jeweils mindestens ein Element der III. Hauptgruppe und mindestens ein Element der V. Hauptgruppe aufweisen. Bevorzugt bestehen die genannten Schichten bzw. Gebiete aus III-V-Materialien, z.B. GaAs, AlGaAs, InGaP, InAlP, InAlGaP, GaAsP, InGaAs oder InP.

Es wird angemerkt, dass ein aus einem III-V-Material bestehendes Gebiet bzw. Schicht nur im Wesentlichen aus III-V-Material bestehen muss bzw. neben einem III-V-Material, also einem Material welches einen oder mehrere Elemente der III. und/oder V. Hauptgruppe umfasst, gegebenenfalls noch Verunreinigungen und/oder Dotierstoffe und/oder Störstellen aufweisen kann.

Entsprechendes gilt für ein aus GaAs oder einer anderen ausdrücklich genannten Materialkombination bestehenden Halbleitergebiet bzw. eine Halbleiterschicht. Weist eine Schicht eine ausdrücklich genannte Materialkombination auf, so wird damit ausgedrückt, dass das Material der Schicht aus einer Verbindung der ausdrücklich genannten Materialien und gegebenenfalls weiteren Elementen der III. und/oder V. Hauptgruppe besteht. Eine GaAs aufweisende Schicht umfasst beispielsweise auch eine InGaAs-Schicht.

In Weiterbildungen weist das photonische III-V-Halbleiterbauelement zusätzlich Halbleiterschichten aus anderen Halbleitermaterialien oder zusätzliche Schichten aus anderen nicht-Halbleiter-Materialien, z.B. eine Nitridschicht oder eine Oxidschicht oder eine Polyimidschicht als weitere Passivierungsschicht, auf.

In einer bevorzugten Ausführungsform bestehen das Absorptionsgebiet und die erste Halbleiterkontaktschicht sowie gegebenenfalls unterhalb des Absorptionsgebiets folgende Halbleiterschichten aus GaAs oder InGaAs oder weisen einen Indium-Gehalt von höchstens 30% auf, da GaAs und InGaAs eine hohe Ladungsträgerbeweglichkeit aufweisen.

Die III-V-Halbleiterpassivierungsschicht besteht bevorzugt aus InGaP oder InAlP oder InAlGaP oder AlGaAs. In einer Weiterbildung weist die III-V-Halbleiterpassivierungsschicht eine höhere Energiebandlücke als das Absorptionsgebiet auf.

III-V-Halbleiter, insbesondere GaAs, liefern eine besonders hohe Elektronenbeweglichkeit von 8800 Vs/cm bei einer Dotierung kleiner als 1•10¹⁵ cm⁻³. Beispielsweise beträgt die Elektronenbeweglichkeit in InGaAs bei einer Dotierung kleiner als 1•10¹⁵ cm⁻³ ca. 12.000 Vs/cm.

Niedrig dotierte dicke Schichten, wie die erfindungsgemäße Absorptionsschicht, lassen sich inzwischen beispielsweise mittels MOVPE oder LPE abscheiden, wodurch ein dem Bauelement entsprechender Schichtstapel auf einfache Weise erzeugt werden kann.

Durch die III-V-Halbleiterpassivierungsschicht werden Leckströme im Randbereich und über die Oberfläche des Halbleiterbauelements bzw. über den Rand verlaufende Strompfade unterdrückt. Untersuchungen haben gezeigt, dass die Durchbruchspannung wesentlich von dem ersten Abstand zwischen der III-V-Halbleiterpassivierungsschicht und der ersten Halbleiterkontaktschicht bestimmt wird.

Mit dem erfindungsgemäßen photonischen Halbleiterbauelement lassen sich Durchbruchfeldstärken von bis zu 40 V/µm oder Durchbruchfeldstärken von über 20 V/µm zuverlässig erreichen.

Ein Vorteil der erfindungsgemäßen Halbleiterstruktur sind ein besonders geringer Sperrstrom und eine hohe Durchbruchspannung. Insbesondere weist die Durchbruchkennlinie einen idealen Verlauf auf.

Mit dem besonders dicken Absorptionsgebiet oberhalb von 80 µm bis zu einer Dicke von 2000 µm oder einer Dicke zwischen 500µm und 2000 µm oder zwischen 800 µm und 2000 µm und der besonders hohen Sperrspannung eignet sich die erfindungsgemäße Halbleiterstruktur besonders als Pixel zur Strahlungsdetektion insbesondere zur Detektion von Röntgenstrahlen. Anders ausgedrückt, das photonische Bauelement eignet sich insbesondere als Röntgendetektor.

Vorzugsweise liegen die Ströme im Betrieb des photonischen Bauelements kleiner als 100mA oder kleiner als 10 mA oder kleiner als 1 mA.

Durch den ersten Abstand der III-V-Halbleiterpassivierungsschicht zu dem Halbleiterkontaktgebiet werden auch bei hohen Sperrspannungen oberhalb von 400 V besonders niedrige Sperrströme kleiner als 1 µA erreicht. Insbesondere liegen die Sperrströme in einem Bereich zwischen 0,5 nA und 50 nA oder unterhalb von 100 nA.

Hierdurch lassen sich hohe Rückwärtsspannungen anlegen, um die mittels einer Absorption erzeugten Ladungsträger in Richtung des p-n Übergangs zu trennen. Es versteht sich, dass sich hierdurch eine sehr hohe Empfindlichkeit des Detektors erzielen lässt.

Außerdem treten an der Grenzfläche zwischen dem Absorptionsgebiet und der III-V-Halbleiterpassivierungsschicht im Vergleich zu einer Grenzfläche eines Absorptionsgebiets zu einer üblichen Passivierungsschicht, wie z.B. Si₃N₄ oder SiO₂, deutlich weniger Rekombinationen auf, wodurch die Empfindlichkeit des Bauelements ebenfalls erhöht wird und die Leckströme wesentlich reduziert werden.

Insbesondere werden durch die III-V-Halbleiterpassivierungsschicht im Vergleich zu einer üblichen SiN oder SiO Passivierungsschicht Oberflächenzustände besser abgesättigt.

Höchst vorteilhaft für die Passivierungswirkung der III-V-Halbleiterpassivierungsschicht ist dabei, dass durch eine im Vergleich zum Absorptionsgebiet erhöhte Energiebandlücke die Ladungsträger von der Oberfläche ferngehalten und so effektiv Leckströme reduziert werden können..

Mittels der besonders dünnen zweiten metallischen Anschlussschicht, bevorzugt nicht flächig sondern punktförmig oder fingerförmig bzw. streifenförmig ausgeführt, und mittels einer dünnen ersten Halbleiterkontaktschicht sowie gegebenenfalls durch Weglassen der zweiten Halbeiterkontaktschicht wird die Durchlässigkeit für Photonen, beispielsweise Röntgenstrahlen, erhöht. Hierdurch eignet sich das erfindungsgemäße photonische Halbleiterbauelement insbesondere als Pixel eines Pixel-Array-Röntgendetektors.

Vorzugsweise weist die zweite metallische Anschlussschicht eine Dicke kleiner als 100 µm und größer als 0,1 nm auf.

Es versteht sich außerdem, dass das photonische Bauelement zur Detektion von Strahlen so ausgerichtet wird, dass diese auf die zweite metallische Anschlusskontaktschicht und die Unterseite des Bauelements auftreffen. Die Begriffe "unten" und "oben" bzw. "unterhalb" und "oberhalb" dienen lediglich dazu, die Anordnung der einzelnen Schichten und Gebiete zueinander zu beschreiben und geben keine absolute Richtung an.

In einer ersten Ausführungsform ist die zweite metallische Anschlusskontaktschicht mit der Unterseite des Absorptionsgebiets oder mit einer Unterseite einer unterhalb des Absorptionsgebiets angeordneten Pufferschicht oder mit einer Unterseite einer unterhalb des Absorptionsgebiets angeordneten Substratschicht stoffschlüssig verbunden.

In einer alternativen Weiterbildung weist das photonische III-V-Halbleiterbauelement eine zumindest gebietsweise ausgebildete hochdotierte zweite Halbleiterkontaktschicht des zweiten Leitfähigkeitstyps mit einer Dotierstoffkonzentration von mindestens 1•10¹⁷ cm⁻³, einer Schichtdicke von höchstens 100 µm oder höchstens 50 µm, einer dem Absorptionsgebiet zugewandte Oberseite und einer Unterseite auf.

Hierbei ist die zweite Halbleiterkontaktschicht unterhalb des Absorptionsgebiets angeordnet und die zweite metallische Anschlusskontaktschicht ist stoffschlüssig mit der Unterseite der zweiten Halbleiterkontaktschicht verbunden.

In einer Weiterbildung weist die zweite Halbleiterkontaktschicht eine Schichtdicke von 0,1 µm - 150 µm oder von 0,1 µm - 50 µm oder von 0,1 µm - 10 µm oder von 0,1 µm - 5 µm auf. Alternativ oder ergänzend weist die zweite Halbleiterkontaktschicht die erste Gitterkonstante auf.

In einer anderen Weiterbildung weist die zweite Halbleiterkontaktschicht die erste Gitterkonstante auf. Die Unterseite des Absorptionsgebiets ist bevorzugt stoffschlüssig mit der Oberseite der zweiten Halbleiterkontaktschicht oder mit einer zwischen dem Absorptionsgebiet und der zweiten Halbleiterkontaktschicht angeordneten Zwischenschicht verbunden.

In einer alternativen Weiterbildung weist die zweite Halbleiterkontaktschicht eine von der ersten Gitterkonstanten abweichende zweite Gitterkonstante auf und zwischen der zweiten Halbleiterkontaktschicht und dem Absorptionsgebiet ist eine Pufferschicht mit der ersten Gitterkonstanten an einer dem Absorptionsgebiet zugewandten Oberseite und der zweiten Gitterkonstante an einer der zweite Halbleiterkontaktschicht zugewandten Unterseite angeordnet.

In einer anderen Weiterbildung ist die zweite Halbleiterkontaktschicht als eine Substratschicht oder als eine Pufferschicht ausgebildet. Anders ausgedrückt weist eine einzige Halbleiterschicht sowohl die Funktion und Eigenschaften der zweiten Halbleiterkontaktschicht als auch der Substratschicht oder der Pufferschicht auf bzw. erfüllt beide Funktionen.

Alternativ ist die zweite Halbleiterkontaktschicht als zusätzliche Schicht epitaktisch erzeugt, beispielsweise auf einem vor einer Metallisierung zu entfernenden Substrat und/oder Pufferschicht und/oder Zwischenschicht.

In einer ersten Ausführungsform weist die III-V-Halbleiterpassivierungsschicht eine Schichtdicke von 0,02 µm - 1 µm oder zwischen 0,02 µm und 10 µm auf.

In einer anderen Ausführungsform weist die III-V-Halbleiterpassivierungsschicht eine größere Bandlücke als das Absorptionsgebiet auf. Insbesondere umfasst die III-V-Halbleiterpassivierungsschicht eine Verbindung aus InGaP oder AlGaAs oder InGaAsP oder InAlP oder InAlGaP oder besteht aus AlGaAs oder aus InGaP oder aus InGaAsP oder aus InAlP oder aus InAlGaP.

In einer anderen Ausführungsform beträgt der erste Abstand der III-V-Halbleiterpassivierungsschicht zu der ersten Halbleiterkontaktschicht mindestens 1% oder mindestens 10 % oder mindestens 50% oder mindestens 75% der Schichtdicke des Absorptionsgebiets.

Es versteht sich, dass der erste Abstand sich nach der Sperrspannung richtet. Je größer die Sperrspannung, umso größer muss der erste Abstand sein. Hieraus ergibt sich ein entsprechender Zusammenhang zwischen dem Abstand und der Schichtdicke des Absorptionsgebiets.

In einer weiteren Ausführungsform umschließt die III-V-Halbleiterpassivierungsschicht in einer Projektion senkrecht zu der Oberseite der ersten Halbleiterkontaktschicht die erste Halbleiterkontaktschicht vollständig.

Die III-V-Halbleiterpassivierungsschicht weist also in der Projektion quasi eine Durchgangsöffnung auf und die erste Halbleiterkontaktschicht ist so innerhalb dieser Durchgangsöffnung angeordnet, dass ein Abstand eines Randes der ersten Halbleiterkontaktschicht zu einem Rand der Durchgangsöffnung immer größer oder gleich dem ersten Abstand ist.

In einer weiteren Ausführungsform weist das stapelförmige photonische III-V-Halbleiterbauelement eine weitere Passivierungsschicht auf, wobei die weitere Passivierungsschicht zumindest eine Oberseite der III-V-Halbleiterpassivierungsschicht, eine der Mesa-Struktur zugewandte Seitenfläche der III-V-Halbleiterpassivierungsschicht und einen Teil einer an die Seitenfläche der III-V-Halbleiterpassivierungsschicht angrenzenden Oberseite des Absorptionsgebiets überdeckt.

Bevorzugt überdeckt die weitere Passivierungsschicht die gesamte sich von der Seitenfläche der III-V-Halbleiterpassivierungsschicht bis zu der Mesa-Struktur erstreckende Oberseite des Absorptionsgebiets, eine Seitenfläche der Mesa-Struktur und einen Teil der ersten metallischen Kontaktschicht, wobei ein weiterer Teil der Oberseite der ersten metallischen Kontaktschicht von der weiteren Passivierungsschicht ausgespart wird.

In einer Weiterbildung umfasst die weitere Passivierungsschicht Si₃N₄ und / oder SiO₂ und / oder SiNOₓ und / oder Polyimid oder besteht aus Si₃N₄ und / oder aus SiO₂ und / oder aus SiNOₓ und / oder aus Polyimid.

In einer weiteren Ausführungsform sind die erste Halbleiterkontaktschicht und/oder das Absorptionsgebiet und/oder die III-V-Halbleiterpassivierungsschicht jeweils epitaktisch auf einer vorausgehenden Schicht des photonischen III-V-Halbleiterbauelements erzeugt.

In einer anderen Weiterbildung weist die zweite metallische Anschlusskontaktschicht eine Schichtdicke von 5 nm - 2 µm oder von 10 nm - 1 µm auf.

Da die zweite metallische Anschlusskontaktschicht auf der Eintrittsseite von zu detektierender Strahlung angeordnet ist, ist eine besonders geringe Schichtdicke gerade bei einer flächigen oder zumindest größere Flächen bedeckenden Ausgestaltung der Anschlusskontaktschicht vorteilhaft, um Verluste beim Eintritt bzw. Durchlaufen der Anschlusskontaktschicht zu minimieren.

Gemäß alternativer Ausführungsformen ist die zweite metallische Anschlusskontaktschicht flächig oder punktförmig oder fingerförmig ausgebildet.

Als flächige Schicht wird eine Anschlusskontaktschicht bezeichnet, welche die Unterseite der untersten Halbleiterschicht des photonischen III-V-Halbleiterbauelements, z.B. das Absorptionsgebiet oder eine zweite Halbleiterkontaktschicht, vollständig oder zumindest zu einem großen Teil, z.B. zu 70%, bedeckt.

Eine fingerförmige Anschlusskontaktschicht bedeckt die Unterseite der untersten Halbleiterschicht nur teilweise mit einzelnen länglichen Anschlusskontaktschichtabschnitten, z.B. streifenförmig. Jeder Anschlusskontaktschichtabschnitt ist einzeln angeschlossen oder über einen beispielsweise quer zu den weiteren Anschlusskontaktschichtabschnitten verlaufenden streifenförmigen weiteren Anschlusskontaktschichtabschnitt verbunden.

Die fingerförmige Ausgestaltung lässt gegebenenfalls größere Teile der Oberfläche der untersten Halbleiterscheibe frei, wodurch Verluste beim Auftreffen von Strahlung verringert bzw. vermieden werden.

Eine punktförmige zweite metallische Anschlusskontaktschicht bedeckt einen noch geringeren Anteil der Oberfläche der untersten Halbleiterschicht des Bauelements und ist daher hinsichtlich von Strahlungsverlusten innerhalb der Anschlusskontaktschicht besonders vorteilhaft.

Bei geringen zu erwartenden Stromstärken sind außerdem keine weiteren Nachteile für eine punktförmige Ausgestaltung zu erwarten.

In einer anderen Weiterbildung weisen die erste Halbleiterkontaktschicht und das Absorptionsgebiet des photonischen III-V-Halbleiterbauelements jeweils GaAs auf oder bestehen jeweils aus GaAs. Ist eine zweite Halbleiterkontaktschicht vorhanden, so weist diese In einer Weiterbildung ebenfalls GaAs auf oder besteht ebenfalls aus GaAs.

In einer anderen Ausführungsform weist die Oberseite der ersten Halbleiterkontaktschicht einen kreisförmigen oder einen ovalen oder einen mehreckigen Umfang auf. Es versteht sich, dass der Umfang der Mesa-Struktur der Form der Oberseite der ersten Halbleiterkontaktschicht entspricht.

In einer weiteren Weiterbildung weist das stapelförmige photonische III-V-Halbleiterbauelement eine metamorphe Pufferschicht auf, wobei die metamorphe Pufferschicht unterhalb der Unterseite des Absorptionsgebiets und oberhalb der ersten metallischen Anschlusskontaktschicht angeordnet ist und an einer dem Absorptionsgebiet zugewandten Oberseite die erste Gitterkonstante und an einer Unterseite eine von der ersten Gitterkonstanten abweichenden zweite Gitterkonstante aufweist.

Vorzugsweise weist die metamorphe Pufferschicht eine Dicke zwischen 2 µm und 5 µm und eine Dotierung zwischen 1•17 cm⁻³ und 1•19 cm⁻³ auf.

In einer ersten Ausführungsform der Pufferschicht, umfasst die metamorphe Pufferschicht wenigstens drei Halbleiterschichten. Vorzugsweise ändert sich die Gitterkonstanten der Halbleiterschichten der metamorphen Pufferschicht von Halbleiterschicht zu Halbleiterschicht. In einer anderen Ausführungsform variiert die Gitterkonstante der Halbleiterschicht stufenlos zwischen den beiden Gitterkonstanten.

Die metamorphe Pufferschicht dient beispielsweise dazu, das Absorptionsgebiet epitaktisch auf einem Substrat zu erzeugen, welches die zweite Gitterkonstante aufweist. Alternativ ermöglicht die Pufferschicht das Ausbilden einer Halbleiterkontaktschicht aus einem Material mit der zweiten Gitterkonstanten.

In einer weiteren Ausführungsform weist das stapelförmige photonische III-V-Halbleiterbauelement alternativ oder ergänzend eine zumindest gebietsweise ausgebildete Halbleiterzwischenschicht mit einer Dotierstoffkonzentration von 1•10¹⁴ - 1•10¹⁶ cm⁻³ sowie eine Schichtdicke von höchstens 50 µm oder höchstens 30 µm auf.

Die Halbleiterzwischenschicht ist oberhalb des Absorptionsgebiets und unterhalb der ersten Halbleiterkontaktschicht angeordnet und weist den ersten Leitfähigkeitstyp und die erste Gitterkonstante auf und/oder die Halbleiterzwischenschicht ist unterhalb des Absorptionsgebiets und oberhalb einer zweiten Halbleiterkontaktschicht angeordnet und weist den zweiten Leitfähigkeitstyp und eine der Gitterkonstanten der zweiten Halbleiterkontaktschicht entsprechende Gitterkonstante auf.

Die im Vergleich zu der nächstliegenden Halbleiterkontaktschicht schwächer dotierte Zwischenschicht gleichen Leitfähigkeitstyps reduziert die Leckströme der Schichtfolge und ermöglicht eine Verbesserung der Hochspannungseigenschaften.

Es versteht sich, dass eine Zwischen dem Absorptionsgebiet und der ersten Halbleiterkontaktschicht angeordnete Zwischenschicht gegebenenfalls als Teil der Mesa-Struktur ausgebildet ist.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: eine Querschnittansicht einer ersten Ausführungsform eines III-V-Halbleiterbauelements,
- Figur 2: eine Aufsicht auf eine Oberseite der ersten Ausführungsform des III-V-Halbleiterbauelements,
- Figur 3: eine Querschnittansicht einer zweiten Ausführungsform des III-V-Halbleiterbauelements,
- Figur 4: eine Querschnittansicht einer dritten Ausführungsform des stapelförmigen photonischen III-V-Halbleiterbauelements,
- Figur 5: eine Querschnittansicht einer vierten Ausführungsform des stapelförmigen photonischen III-V-Halbleiterbauelements,
- Figur 6: eine Querschnittansicht einer fünften Ausführungsform des stapelförmigen photonischen III-V-Halbleiterbauelements,
- Figur 7: eine Aufsicht auf eine Unterseite einer sechsten Ausführungsform des stapelförmigen III-V-Halbleiterbauelements,
- Figur 8: eine Aufsicht auf eine Unterseite einer siebten Ausführungsform des stapelförmigen III-V-Halbleiterbauelements.

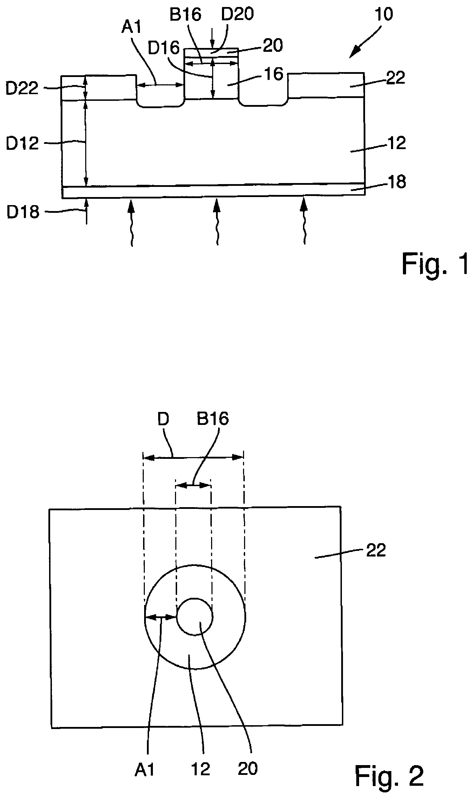

Die Abbildung der Figur 1 zeigt ein photonisches III-V-Halbleiterbauelement 10 mit einem Absorptionsgebiet 12, einer ersten Halbleiterkontaktschicht 16, einer ersten metallischen Anschlusskontaktschicht 20, einer zweiten metallischen Anschlusskontaktschicht 18 sowie einer III-V-Halbleiterpassivierungsschicht 22.

Das Absorptionsgebiet 12 ist als Halbleiterschicht ausgebildet und weist Dotierstoffe eines zweiten Leitfähigkeitstyps mit einer Dotierstoffkonzentration von höchstens 10¹⁶ cm⁻³ und eine Schichtdicke D12 von mindestens 80 µm bevorzugt mindestens 500 µm auf.

An einer Unterseite des Absorptionsgebiets 12 folgt stoffschlüssig die zweite metallische Anschlusskontaktschicht 18, wobei die zweite Anschlusskontaktschicht 18 die Unterseite des Absorptionsgebiets 12 flächig überdeckt und eine geringe Schichtdicke D18 aufweist.

Die zweite metallische Anschlusskontaktschicht 18 ist als dünne Metallschicht oder als mehrere streifen- bzw. fingerförmige Metallschichtabschnitte mit einer Schichtdicke D18 von höchstens 500 nm, z.B. 10 nm, auf einer Unterseite des Absorptionsgebiets 12 ausgebildet.

Die erste Halbleiterkontaktschicht 16 ist als Mesa-Struktur mit einer Mesa-Breite B16 und einer Schichtdicke D16 auf einem ersten Oberflächenabschnitt der Oberseite des Absorptionsgebiets 12 angeordnet und mit dem ersten Oberflächenabschnitt stoffschlüssig verbunden.

Die erste Halbleiterkontaktschicht 16 weist einen ersten Leitfähigkeitstyp, also einen von dem Leitfähigkeitstyps des Absorptionsgebiets 12 abweichenden Leitfähigkeitstyp und eine Dotierstoffkonzentration von mindestens 1•10¹⁸ cm⁻³ auf.

Die erste metallische Anschlusskontaktschicht 20 bedeckt eine Oberseite der ersten Halbleiterkontaktschicht 16, weist eine Schichtdicke D20 auf und ist stoffschlüssig mit einer Oberseite der ersten Halbleiterkontaktschicht 16 verbunden.

In einem Abstand A1 um die Mesa-Struktur, also um den ersten Oberflächenabschnitt und die erste Halbleiterkontaktschicht 16, ist auf der Oberseite des Absorptionsgebiets 12 die III-V-Halbleiterpassivierungsschicht 22 mit einer Schichtdicke D22 angeordnet.

Alle Halbleiterschichten des photonischen III-V-Halbleiterbauelements, also das Absorptionsgebiet 12, die Halbleiterkontaktschicht 16 und die III-V-Halbleiterpassivierungsschicht 22, sind zueinander gitterangepasst, weisen also alle eine erste Gitterkonstante auf.

Im dargestellten Ausführungsbeispiel weist die Oberfläche des Absorptionsgebiets 12 in dem zwischen der III-V-Halbleiterpassivierungsschicht 22 und der Mesa-Struktur freiliegenden Bereich eine graben-förmige Vertiefung auf, welche beispielsweise durch einen Ätzprozess während der Herstellung des III-V-Halbleiterbauelements 10 entsteht.

Der erste Leitfähigkeitstyp ist beispielsweise p und der zweite Leitfähigkeitstyp ist n, so dass sich eine p-auf-n Struktur ergibt. Alternativ ist der erste Leitfähigkeitstyp n und der zweite Leitfähigkeitstyp p und es ergibt sich eine n-auf-p Struktur.

Es versteht sich, dass die Begriffe "oben", "oberhalb", "unten" und "unterhalb" nur zur Anordnung der einzelnen Gebiete und Schichten relativ zueinander dienen und keine absolute Richtung angeben.

Das III-V-Halbleiterbauelement 10 ist dazu ausgelegt, Photonen, z.B. Röntgenstrahlen, zu detektieren, welche auf die Unterseite, also die zweite metallische Anschlusskontaktschicht 18 einfallen.

In der Abbildung der Figur 2 ist eine Aufsicht auf die erste Ausführungsform des photonischen III-V-Halbleiterbauelements 10 dargestellt. Im Folgenden werden nur die Unterschiede zu der Abbildung der Figur 1 erläutert.

Die erste Halbleiterkontaktschicht 16 sowie die erste metallische Anschlusskontaktschicht 20 weisen jeweils einen kreisförmigen Umfang und einen Durchmesser mit der Kantenlänge B16 auf.

Die Mesa-Struktur ist von einem freiliegenden Abschnitt der Oberseite des Absorptionsgebiets 12 umgeben, wobei der Abschnitt durchgehend eine dem Abstand A1 entsprechende Breite aufweist. Die restliche Oberfläche des Absorptionsgebiets 12 ist vollständig von der III-V-Halbleiterpassivierungsschicht 22 überdeckt. Die III-V-Halbleiterpassivierungsschicht 22 weist somit eine kreisförmige Aussparung mit einer Kantenlänge D auf, wobei die Kantenlänge der Summe aus der Kantenlänge B16 der ersten Halbleiterkontaktschicht 16 und der doppelten Breite A1 entspricht.

Nicht dargestellt sind Ausführungsformen mit einem ovalen oder beliebig vieleckigen, z.B. achteckigen oder rechteckigen Umfang der Mesa-Struktur.

Es versteht sich, dass die Aussparung der III-V-Halbleiterpassivierungsschicht 22 nicht unbedingt die Form des Umfangs der Mesa-Struktur aufweisen muss.

Die Form von der Aussparung in der III-V-Passivierungsschicht und des Umfangs der Mesa-Struktur unterliegen der Bedingung, dass an jedem Punkt ein Abstand A1 von einem gegebenen Mindestwert erfüllt sein muss.

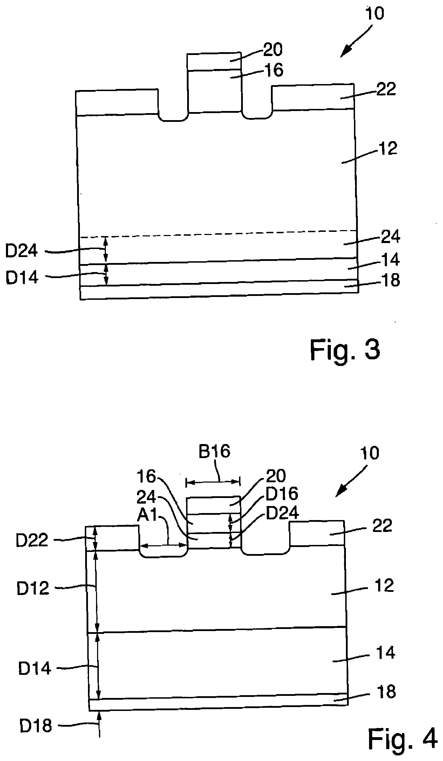

In der Abbildung der Figur 3 ist eine Schnittansicht einer zweiten Ausführungsform des photonischen III-V-Halbleiterbauelements dargestellt. Im Folgenden werden nur die Unterschiede zu der Abbildung der Figur 1 erläutert.

Das III-V-Halbleiterbauelement 10 weist zusätzlich eine zweite Halbleiterkontaktschicht 14 auf, wobei die zweite Halbleiterkontaktschicht 14 den zweiten Leitfähigkeitstyp mit einer Dotierstoffkonzentration von mindestens 10•10¹⁸ cm ⁻³ und eine geringe Schichtdicke D14 aufweist. Die zweite Halbleiterkontaktschicht 14 weist also denselben Leitfähigkeitstyp wie das Absorptionsgebiet 12 auf.

Die zweite Halbleiterkontaktschicht 14 ist zwischen dem Absorptionsgebiet 12 und der zweiten metallischen Anschlusskontaktschicht 18 angeordnet und mit beiden jeweils stoffschlüssig verbunden.

Optional (gestrichelt dargestellt) weist das photonische III-V-Halbleiterbauelement zusätzlich eine Halbleiterzwischenschicht 24 mit einer Schichtdicke D24 auf, wobei die Halbleiterzwischenschicht den zweiten Leitfähigkeitstyp, also denselben Leitfähigkeitstyp wie die zweite Halbleiterkontaktschicht 14 und das Absorptionsgebiet 12, aufweist.

Eine Dotierstoffkonzentration der Halbleiterzwischenschicht beträgt zwischen 1•10¹⁴ und 1•10¹⁶ cm⁻³ und liegt damit zwischen der sehr niedrigen Dotierung des Absorptionsgebiets 12 und der sehr hohen Dotierung des zweiten Halbleiterkontaktgebiets 14.

In der Abbildung der Figur 4 ist eine Schnittansicht einer dritten Ausführungsform des stapelförmigen photonischen III-V-Halbleiterbauelements 10 dargestellt. Im Folgenden werden nur die Unterschiede zu der Abbildung der Figur 1 und 3 erläutert.

Das stapelförmige photonische III-V-Bauelement 10 weist die Halbleiterzwischenschicht 24 auf, wobei die Halbleiterzwischenschicht 24 zwischen dem Absorptionsgebiet 12 und dem ersten Halbleiterkontaktgebiet 16 angeordnet ist, als Teil der Mesa-Struktur ausgebildet ist und den ersten Leitfähigkeitstyp aufweist.

In einer nicht dargestellten Ausführungsform weist das photonische III-V-Halbleiterbauelement sowohl die Halbleiterzwischenschicht gemäß Fig. 3 als auch die Halbleiterzwischenschicht gemäß Fig. 4, also zwei Halbleiterzwischenschichten auf.

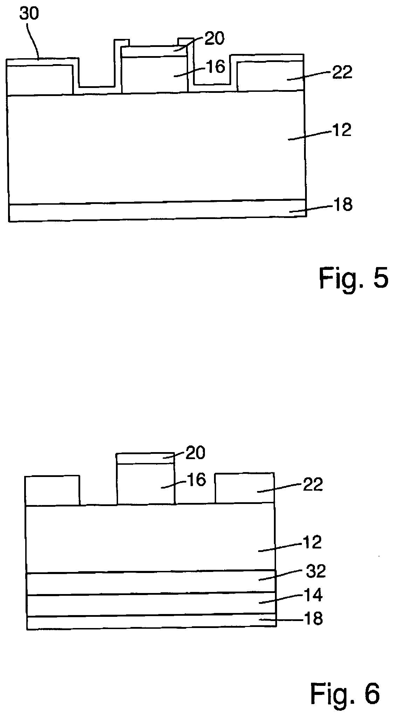

In der Abbildung der Figur 5 ist eine Schnittansicht einer vierten Ausführungsform des stapelförmigen photonischen III-V-Halbleiterbauelements dargestellt. Im Folgenden werden nur die Unterschiede zu der Abbildung der Figur 1 erläutert.

Gemäß der vierten Ausführungsform weist das photonische III-V-Halbleiterbauelement 10 zusätzlich eine weitere Passivierungsschicht 30 auf, wobei die weitere Passivierungsschicht 30 eine Oberseite sowie der Mesa-Struktur zugewandte Seitenflächen der III-V-Halbleiterpassivierungsschicht 22, den sich zwischen der Mesa-Struktur und der III-V-Halbleiterpassivierungsschicht erstreckenden Teil der Oberfläche des Absorptionsgebiets 12, eine Seitenfläche der Mesa-Struktur und einen äußeren Randbereich einer Oberseite der ersten metallischen Anschlusskontaktschicht 20 überdeckt.

Außerdem weist das III-V-Halbleiterbauelement 10 in dem dargestellten Ausführungsbeispiel keinen Graben in dem freiliegenden Bereich der Oberseite des Absorptionsgebiets 12 zwischen der III-V-Halbleiterpassivierungsschicht 22 und der Mesa-Struktur auf, was beispielsweise durch einen anderen Prozessablauf während der Herstellung erreicht wird.

Es versteht sich, dass das Vorhandensein bzw. Fehlen des Grabens auch unabhängig von der weiteren Passivierungsschicht 30 erreicht wird.

In einer anderen nicht dargestellten Ausführungsform überdeckt die weitere Passivierungsschicht 30 nur die Oberseite und die der Mesa-Struktur zugewandten Seitenflächen der III-V-Halbleiterpassivierungsschicht 22 sowie einen an die III-V-Halbleiterpassivierungsschicht 22 angrenzenden Bereich der freiliegenden Oberseite des Absorptionsgebiets 12.

In der Abbildung der Figur 6 ist eine Schnittansicht einer fünften Ausführungsform des stapelförmigen photonischen III-V-Halbleiterbauelements dargestellt. Im Folgenden werden nur die Unterschiede zu der Abbildung der Figur 3 und 5 erläutert.

Das photonische III-V-Halbleiterbauelement 10 weist zusätzlich eine Pufferschicht 32 auf, wobei die Pufferschicht 32 an einer Oberseite die erste Gitterkonstante und an einer Unterseite eine zweite Gitterkonstante aufweist. Die Oberseite der Pufferschicht 32 ist stoffschlüssig mit der Unterseite des Absorptionsgebiets 12 verbunden und die Unterseite der Pufferschicht 32 ist stoffschlüssig mit der Oberseite der zweiten hochdotierten Halbleiterkontaktschicht 14 verbunden. Die zweite Halbleiterkontaktschicht 14 weist die zweite Gitterkonstante auf.

In einer alternativen, nicht dargestellten Ausführungsform weist das photonische III-V-Halbleiterbauelement die Pufferschicht 32, aber keine zweite Halbleiterkontaktschicht 14 auf, so dass die erste metallische Anschlusskontaktschicht 18 stoffschlüssig mit der Unterseite der Pufferschicht 32 verbunden ist. In einer Weiterbildung fungiert die Pufferschicht 32 als zweite Halbleiterkontaktschicht 14.

Ebenfalls nicht dargestellt sind weitere Ausführungsformen, bei denen das photonische III-V-Halbleiterbauelement 10 statt der Pufferschicht 32 eine Substratschicht mit der ersten Gitterkonstanten oder zusätzlich zu der Pufferschicht 32 und unterhalb der Pufferschicht 32 angeordnet eine Substratschicht mit der zweiten Gitterkonstanten aufweist.

Es versteht sich, dass die beiden vorgenannten Ausführungsformen sowohl mit der hochdotierten zweiten Halbleiterkontaktschicht 14 als auch ohne die zweite Halbleiterkontaktschicht 14 realisiert werden können bzw. dass eine Halbleiterschicht auch gleichzeitig die Funktion einer Pufferschicht und einer zweiten Halbleiterkontaktschicht bzw. die Funktion einer Substratschicht und einer zweite Halbleiterkontaktschicht übernehmen bzw. erfüllen kann.

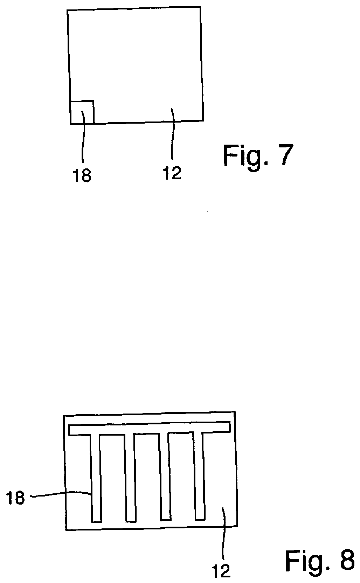

In den Abbildungen der Figuren 7 und 8 sind Aufsichten auf eine Unterseite einer sechsten und siebten Ausführungsform des stapelförmigen photonischen III-V-Halbleiterbauelements dargestellt. Im Folgenden werden nur die Unterschiede zu der Abbildung der Figur 1 erläutert.

In Figur 7 ist eine punktförmige Ausgestaltung der zweiten metallischen Anschlusskontaktschicht 18 dargestellt, wobei die Anschlusskontaktschicht 18 einen quadratischen Umfang aufweist und in einer Ecke der Unterseite des Absorptionsgebiets 12 angeordnet ist.

Nicht dargestellt sind Ausführungsformen mit einer punktförmigen Anschlusskontaktschicht 18 mit rechteckigem, mehreckigem, kreisförmigem oder ovalem Umfang und einer beliebigen Position auf der Unterseite des Absorptionsgebiets.

Ebenso wenig dargestellt sind Ausführungsformen bei denen die punktförmige Anschlusskontaktschicht 18 auf einer zweiten Anschlusskontaktschicht 14 oder einer anderen Halbleiterzwischenschicht 24 angeordnet ist.

In der Figur 8 ist eine fingerförmige Ausgestaltung der zweiten metallischen Anschlusskontaktschicht 18 dargestellt, wobei die einzelnen fingerförmigen Abschnitte der Anschlusskontaktschicht 18 gemäß der dargestellten Ausführung parallel zueinander verlaufen und mittels eines quer verlaufenden fingerförmigen Abschnitts elektrisch leitend verbunden sind.

Es versteht sich, dass die Ausführungsformen der Figuren miteinander kompatibel sind.

## Patentansprüche

1. Stapelförmiges photonisches III-V-Halbleiterbauelement (10) ausgebildet als eine n-auf p oder eine p- auf n Struktur, aufweisend
- eine zumindest gebietsweise ausgebildete erste metallische Anschlusskontaktschicht (20),
- eine zumindest gebietsweise ausgebildete hochdotierte erste Halbleiterkontaktschicht (16) eines ersten Leitfähigkeitstyps mit einer Dotierstoffkonzentration von mindestens 1•10¹⁸ cm⁻³ und mit einer ersten Gitterkonstanten,
- ein Absorptionsgebiet (12) eines zweiten Leitfähigkeitstyps mit einer Dotierstoffkonzentration von 8•10¹¹ cm⁻³ - 8•10¹⁴ cm⁻³, einer Schichtdicke (D12) von 80 µm - 2000 µm mit einer ersten Energiebandlücke und mit der ersten Gitterkonstanten,
- die Halbleiterkontaktschicht (16) und das als Halbleiterschicht ausgebildete Absorptionsgebiet (12) jeweils mindestens ein Element der III. Hauptgruppe und mindestens ein Element der V. Hauptgruppe aufweisen,
- eine zumindest gebietsweise ausgebildete zweite metallische Anschlusskontaktschicht (18), wobei
- die erste Halbleiterkontaktschicht (16) als Mesa-Struktur mit einer Unterseite, einer Oberseite, einer Mesa-Breite (B16) und einer Mesa-Höhe (D16) ausgebildet ist und die Unterseite der ersten Halbleiterkontaktschicht (16) auf oder oberhalb eines ersten Oberflächenabschnitts einer Oberseite des Absorptionsgebiets (12) mit einer mit der Mesa-Breite (B16) übereinstimmenden Breite angeordnet ist,
- eine Unterseite der ersten metallischen Anschlusskontaktschicht (20) stoffschlüssig mit der Oberseite der ersten Halbleiterkontaktschicht (16) verbunden ist und
- die zweite metallische Anschlusskontaktschicht (18) unterhalb einer Unterseite des Absorptionsgebiets (12) angeordnet ist, worin
- das stapelförmige photonische III-V-Halbleiterbauelement (10) eine III-V-Halbleiterpassivierungsschicht (22) mit der ersten Gitterkonstanten und einer sich von der ersten Energiebandlücke unterscheidenden zweiten Energiebandlücke aufweist, wobei
- die III-V-Halbleiterpassivierungsschicht (22) den ersten oder den zweiten Leitfähigkeitstyp und eine Dotierstoffkonzentration von 1•10¹⁴ cm⁻³ - 5 •10¹⁸ cm⁻³ aufweist,
- die III-V-Halbleiterpassivierungsschicht (22) in einem ersten Abstand (A1) von mindestens 0,2 µm zu der Mesa-Struktur der ersten Halbleiterkontaktschicht auf der Oberseite des Absorptionsgebiets (12) angeordnet und mit der Oberseite des Absorptionsgebiets (12) stoffschlüssig verbunden ist.

2. Stapelförmiges photonisches III-V-Halbleiterbauelement (10) nach Anspruch 1, **dadurch gekennzeichnet, dass** die zweite metallische Anschlusskontaktschicht (18) mit der Unterseite des Absorptionsgebiets (12) oder mit einer Unterseite einer unterhalb des Absorptionsgebiets (12) angeordneten Pufferschicht (32) oder mit einer Unterseite einer unterhalb des Absorptionsgebiets (12) angeordneten Substratschicht stoffschlüssig verbunden ist.

3. Stapelförmiges photonisches III-V-Halbleiterbauelement (10) nach Anspruch 1, **dadurch gekennzeichnet, dass** das photonische III-V-Halbleiterbauelement (10) eine zumindest gebietsweise ausgebildete hochdotierte zweite Halbleiterkontaktschicht (14) des zweiten Leitfähigkeitstyps mit einer Dotierstoffkonzentration von mindestens 1•10¹⁷ cm⁻³, einer Schichtdicke (D14) von höchstens 100 µm oder höchstens 50 µm, einer dem Absorptionsgebiet (12) zugewandte Oberseite und einer Unterseite aufweist, wobei die zweite Halbleiterkontaktschicht (14) unterhalb des Absorptionsgebiets (12) angeordnet ist und die zweite metallische Anschlusskontaktschicht (18) stoffschlüssig mit der Unterseite der zweite Halbleiterkontaktschicht (14) verbunden ist.

4. Stapelförmiges photonisches III-V-Halbleiterbauelement nach Anspruch 3, **dadurch gekennzeichnet, dass** die zweite Halbleiterkontaktschicht (14) eine Schichtdicke von 0,1 µm - 150 µm-aufweist.

5. Stapelförmiges photonisches III-V-Halbleiterbauelement (10) nach Anspruch 3 oder 4, **dadurch gekennzeichnet, dass** die zweite Halbleiterkontaktschicht (14) die erste Gitterkonstante aufweist.

6. Stapelförmiges photonisches III-V-Halbleiterbauelement (10) nach Anspruch 5, **dadurch gekennzeichnet, dass** die Unterseite des Absorptionsgebiets (12) stoffschlüssig mit der Oberseite der zweite Halbleiterkontaktschicht (14) verbunden ist.

7. Stapelförmiges photonisches III-V-Halbleiterbauelement (10) nach Anspruch 3 oder 4, **dadurch gekennzeichnet, dass** die zweite Halbleiterkontaktschicht (14) eine von der ersten Gitterkonstanten abweichende zweite Gitterkonstante aufweist und zwischen der zweite Halbleiterkontaktschicht (14) und dem Absorptionsgebiet (12) eine Pufferschicht (32) mit der ersten Gitterkonstanten an einer dem Absorptionsgebiet zugewandten Oberseite und der zweiten Gitterkonstanten an einer der zweite Halbleiterkontaktschicht zugewandten Unterseite angeordnet ist.

8. Stapelförmiges photonisches III-V-Halbleiterbauelement (10) nach einem der Ansprüche 3 bis 6, **dadurch gekennzeichnet, dass** die zweite Halbleiterkontaktschicht (14) als eine Substratschicht oder als eine Pufferschicht (32) ausgebildet ist.

9. Stapelförmiges photonisches III-V-Halbleiterbauelement (10) nach einem der vorangegangenen Ansprüche, **dadurch gekennzeichnet, dass** die III-V-Halbleiterpassivierungsschicht (22) eine Schichtdicke von 0,02 µm - 1 µm aufweist.

10. Stapelförmiges photonisches III-V-Halbleiterbauelement (10) nach einem der vorangegangenen Ansprüche, **dadurch gekennzeichnet, dass** die III-V-Halbleiterpassivierungsschicht (22) InGaP oder AlGaAs oder InGaAsP oder InAlP oder InAlGaP aufweist oder aus InGaP oder aus AlGaAs oder aus InGaAsP oder aus InAlP oder aus InAlGaP besteht.

11. Stapelförmiges photonisches III-V-Halbleiterbauelement (10) nach einem der vorangegangenen Ansprüche, **dadurch gekennzeichnet, dass** der erste Abstand (A1) der III-V-Halbleiterpassivierungsschicht (22) zu der ersten Halbleiterkontaktschicht (16) mindestens 1% der Schichtdicke (D12) des Absorptionsgebiets (12) beträgt.

12. Stapelförmiges photonisches III-V-Halbleiterbauelement nach einem der vorangegangenen Ansprüche, **dadurch gekennzeichnet, dass** die III-V-Halbleiterpassivierungsschicht (22) in einer Projektion senkrecht zu der Oberseite der ersten Halbleiterkontaktschicht (12) die erste Halbleiterkontaktschicht (16) vollständig umschließt.

13. Stapelförmiges photonisches III-V-Halbleiterbauelement (10) nach einem der vorangegangenen Ansprüche, **dadurch gekennzeichnet, dass** das III-V-Halbleiterbauelement eine weitere Passivierungsschicht (30) aufweist, wobei die weitere Passivierungsschicht (30) zumindest eine Oberseite der III-V-Halbleiterpassivierungsschicht (22), eine der Mesa-Struktur zugewandte Seitenfläche der III-V-Halbleiterpassivierungsschicht (22) und einen an die Seitenfläche der III-V-Halbleiterpassivierungsschicht (22) angrenzenden Teil einer Oberseite des Absorptionsgebiet (12) bedeckt.

14. Stapelförmiges photonisches III-V-Halbleiterbauelement (10) nach Anspruch 13, **dadurch gekennzeichnet, dass** die weitere Passivierungsschicht (30) Si₃N₄ und / oder SiO₂ und / oder SiNOₓ und / oder Polyimid umfasst oder aus Si₃N₄ und / oder aus SiO₂ und / oder aus SiNOₓ und / oder aus Polyimid besteht.

15. Stapelförmiges photonisches III-V-Halbleiterbauelement (10) nach einem der vorangegangenen Ansprüche, **dadurch gekennzeichnet, dass** die erste Halbleiterkontaktschicht (16) und/oder das Absorptionsgebiet (12) und/oder die III-V-Halbleiterpassivierungsschicht (22) jeweils epitaktisch auf einer vorausgehenden Schicht des photonischen III-V-Halbleiterbauelements (10) erzeugt sind.

16. Stapelförmiges photonisches III-V-Halbleiterbauelement (10) nach einem der vorangegangenen Ansprüche, **dadurch gekennzeichnet, dass** die zweite metallische Anschlusskontaktschicht (18) eine Schichtdicke von 5 nm - 2 µm aufweist.

17. Stapelförmiges photonisches III-V-Halbleiterbauelement (10) nach einem der vorangegangenen Ansprüche, **dadurch gekennzeichnet, dass** die zweite metallische Anschlusskontaktschicht (18) punktförmig oder flächig oder fingerförmig ausgebildet ist.

18. Stapelförmiges photonisches III-V-Halbleiterbauelement (10) nach einem der vorangegangenen Ansprüche, **dadurch gekennzeichnet, dass** die erste Halbleiterkontaktschicht (16) und das Absorptionsgebiet (12) jeweils GaAs aufweisen oder jeweils aus GaAs bestehen.

19. Stapelförmiges photonisches III-V-Halbleiterbauelement (10) nach einem der vorangegangenen Ansprüche, **dadurch gekennzeichnet, dass** die Oberseite der ersten Halbleiterkontaktschicht (16) einen kreisförmigen oder einen ovalen oder einen mehreckigen Umfang aufweist.

20. Stapelförmiges photonisches III-V-Halbleiterbauelement (10) nach Anspruch 1, **dadurch gekennzeichnet, dass** das stapelförmige photonische III-V-Halbleiterbauelement (10) eine Pufferschicht (32) aufweist, wobei die Pufferschicht (32) unterhalb der Unterseite des Absorptionsgebiets (12) und oberhalb der zweiten metallischen Anschlusskontaktschicht (18) angeordnet ist und an einer dem Absorptionsgebiet zugewandten Oberseite die erste Gitterkonstante und an einer der zweiten metallischen Anschlusskontaktschicht (18) zugewandten Unterseite eine von der ersten Gitterkonstanten abweichende zweite Gitterkonstante aufweist.

21. Stapelförmiges photonisches III-V-Halbleiterbauelement (10) nach einem der vorangegangenen Ansprüche, **dadurch gekennzeichnet, dass** das stapelförmige photonische III-V-Halbleiterbauelement (10) eine zumindest gebietsweise ausgebildete Halbleiterzwischenschicht (24) mit einer Dotierstoffkonzentration von 1•10¹⁴ - 1•10¹⁶ cm⁻³ sowie eine Schichtdicke (D24) von höchstens 50 µm aufweist, wobei die Halbleiterzwischenschicht (24) oberhalb des Absorptionsgebiets (12) und unterhalb der ersten Halbleiterkontaktschicht (16) angeordnet ist und den ersten Leitfähigkeitstyp und die erste Gitterkonstante aufweist und/oder die Halbleiterzwischenschicht (24) unterhalb des Absorptionsgebiets (12) und oberhalb einer zweiten Halbleiterkontaktschicht (14) angeordnet ist und den zweiten Leitfähigkeitstyp und eine der Gitterkonstanten der zweiten Halbleiterkontaktschicht (14) entsprechende Gitterkonstante aufweist.

22. Stapelförmiges photonisches III-V-Halbleiterbauelement (10) nach einem der Ansprüchen 1 oder 2, **dadurch gekennzeichnet, dass** die zweit Energiebandlücke der III-V-Halbleiterpassivierungsschicht (22) größer als die erste Energiebandlücke des Absorptionsgebiets (12) ist.

## Claims

1. Stacked photonic III-V semiconductor component (10) constructed as an n-on-p or a p-on-n structure, comprising
- an at least regionally formed first metallic terminal contact layer (20),
- an at least regionally formed high-doped first semiconductor contact layer (16) of a first conductivity type with a dopant concentration of at least 1•10¹⁸ cm⁻³ and with a first lattice constant,
- an absorption region (12) of a second conductivity type with a dopant concentration of 8•10¹¹ cm ⁻³ to 8•10¹⁴ cm⁻³, a layer thickness (D12) of 80 µm to 2,000 µm with a first energy band gap and with the first lattice constant,
- the semiconductor contact layer (16) and the absorption region (12), which is formed as semiconductor layer, each comprise at least one element of the III main group and at least one element of the V main group,
- an at least regionally formed second metallic terminal contact layer (18), wherein
- the first semiconductor contact layer (16) is formed as a mesa structure with a lower side, an upper side, a mesa width (B16) and a mesa height (D16) and the lower side of the first semiconductor contact layer (16) is arranged on or above a first surface section of an upper side of the absorption region (12) with a width corresponding with the mesa width (B16),
- a lower side of the first metallic terminal contact layer (20) is connected by material couple with the upper side of the first semiconductor contact layer (16) and
- the second metallic terminal contact layer (18) is arranged below a lower side of the absorption region (12),
wherein
- the stacked photonic III-V semiconductor component (10) comprises a III-V semiconductor passivation layer (22) with the first lattice constant and a second energy band gap differing from the first energy band gap, wherein
- the III-V semiconductor passivation layer (22) has the first or the second conductivity type and a dopant concentration of 1•10¹⁴ cm⁻³ to 5•10¹⁸ cm⁻³,
- the III-V semiconductor passivation layer (22) is arranged at a first spacing (A1) of at least 0.2 µm from the mesa structure of the first semiconductor contact layer on the upper side of the absorption region (12) and is connected by material couple with the upper side of the absorption region (12).

2. Stacked photonic III-V semiconductor component (10) according to claim 1, **characterised in that** the second metallic terminal contact layer (18) is connected by material couple with the lower side of the absorption region (12) or with a lower side of a buffer layer (32) arranged below the absorption region (12) or with a lower side of a substrate layer arranged below the absorption region (12).

3. Stacked photonic III-V semiconductor component (10) according to claim 1, **characterised in that** the photonic III-V semiconductor component (10) comprises an at least regionally formed high-doped second semiconductor contact layer (14) of the second conductivity type with a dopant concentration of at least 1•10¹⁷ cm⁻³, a layer thickness (D14) of at most 100 µm or at most 50 µm, an upper side facing the absorption region (12) and a lower side, wherein the second semiconductor contact layer (14) is arranged below the absorption region (12) and the second metallic terminal contact layer (18) is connected by material couple with the lower side of the second semiconductor contact layer (14).

4. Stacked photonic III-V semiconductor component (10) according to claim 3, **characterised in that** the second semiconductor contact layer (14) has a layer thickness of 0.1 µm to 150 µm.

5. Stacked photonic III-V semiconductor component (10) according to claim 3 or 4, **characterised in that** the second semiconductor contact layer (14) has the first lattice constant.

6. Stacked photonic III-V semiconductor component (10) according to claim 5, **characterised in that** the lower side of the absorption region (12) is connected by material couple with the upper side of the second semiconductor contact layer (14).

7. Stacked photonic III-V semiconductor component (10) according to claim 3 or 4, **characterised in that** the second semiconductor contact layer (14) has a second lattice constant differing from the first lattice constant and a buffer layer (32) is arranged between the second semiconductor contact layer (14) and the absorption region (12), the buffer layer having the first lattice constant at an upper side facing the absorption region and the second lattice constant at a lower side facing the second semiconductor contact layer.

8. Stacked photonic III-V semiconductor component (10) according to any one of claims 3 to 6, **characterised in that** the second semiconductor layer (14) is formed as a substrate layer or a buffer layer (32).

9. Stacked photonic III-V semiconductor component (10) according to any one of the preceding claims, **characterised in that** the III-V semiconductor passivation layer (22) has a layer thickness of 0.02 µm to 1 µm.

10. Stacked photonic III-V semiconductor component (10) according to any one of the preceding claims, **characterised in that** the III-V semiconductor passivation layer (22) comprises InGaP or AlGaAs or InGaAsP or InAlP or InAlGaP or consists of InGaP or AlGaAs or InGaAsP or InAlP or InAlGaP.

11. Stacked photonic III-V semiconductor component (10) according to any one of the preceding claims, **characterised in that** the first spacing (A1) of the III-V semiconductor passivation layer (22) from the first semiconductor contact layer (16) is at least 1% of the layer thickness (D12) of the absorption region (12).

12. Stacked photonic III-V semiconductor component (10) according to any one of the preceding claims, **characterised in that** the III-V semiconductor passivation layer (22) completely surrounds the first semiconductor contact layer (16) in a projection perpendicular to the upper side of the first semiconductor contact layer (12).

13. Stacked photonic III-V semiconductor component (10) according to any one of the preceding claims, **characterised in that** the III-V semiconductor component comprises a further passivation layer (30), wherein the further passivation layer (30) covers at least an upper side of the III-V semiconductor passivation layer (22), a side surface, which faces the mesa structure, of the III-V semiconductor passivation layer (22) and a part, which adjoins the side surface of the III-V semiconductor passivation layer (22), of an upper side of the absorption region (12).

14. Stacked photonic III-V semiconductor component (10) according to claim 13, **characterised in that** the further passivation layer (30) comprises Si₃N₄ and/or SiO₂ and/or SiNOₓ andor polyimide or consists of Si₃N₄ and/or SiO₂ and/or SiNOₓ andor polyimide.

15. Stacked photonic III-V semiconductor component (10) according to any one of the preceding claims, **characterised in that** the first semiconductor contact layer (16) and/or the absorption region (12) and/or the III-V semiconductor passivation layer (22) are each produced epitaxially on a preceding layer of the photonic III-V semiconductor component (10).

16. Stacked photonic III-V semiconductor component (10) according to any one of the preceding claims, **characterised in that** the second metallic terminal contact layer (18) has a layer thickness of 5 nm - 2 µm.

17. Stacked photonic III-V semiconductor component (10) according to any one of the preceding claims, **characterised in that** the second metallic terminal contact layer (18) is formed punctiformly or areally or in finger shape.

18. Stacked photonic III-V semiconductor component (10) according to any one of the preceding claims, **characterised in that** the first semiconductor contact layer (16) and the absorption region (12) each comprise GaAs or each consist of GaAs.

19. Stacked photonic III-V semiconductor component (10) according to any one of the preceding claims, **characterised in that** the upper side of the first semiconductor contact layer (16) has a circular or an oval or a polygonal circumference.

20. Stacked photonic III-V semiconductor component (10) according to claim 1, **characterised in that** the stacked photonic III-V semiconductor component (10) comprises a buffer layer (32), wherein the buffer layer (32) is arranged below the lower side of the absorption region (12) and above the second metallic terminal contact layer (18) and has at an upper side facing the absorption region the first lattice constant and at a lower side facing the second metallic terminal contact layer (18) a second lattice constant differing from the first lattice constant.

21. Stacked photonic III-V semiconductor component (10) according to any one of the preceding claims, **characterised in that** the stacked photonic III-V semiconductor component (10) comprises an at least regionally formed semiconductor intermediate layer (24) with a dopant concentration of 1•10¹⁴ to 1•10¹⁶ cm⁻³ as well as a layer thickness (D24) of at most 50 µm, wherein the semiconductor intermediate layer (24) is arranged above the first absorption region (12) and below the first semiconductor contact layer (16) and has the first conductivity type and the first lattice constant and/or the semiconductor intermediate layer (24) is arranged below the absorption region (12) and above a second semiconductor contact layer (14) and has the second conductivity type and a lattice constant corresponding with the lattice constant of the second semiconductor contact layer (14).

22. Stacked photonic III-V semiconductor component (10) according to one of claims 1 and 2, **characterised in that** the second energy band gap of the III-V semiconductor passivation layer (22) is larger than the first energy band gap of the absorption region (12).

## Revendications

1. Dispositif photonique semi-conducteur III-V empilé (10) formé comme une structure n sur p ou p sur n, comprenant
- une première couche de contact métallique (20) formée au moins par zones,
- une première couche de contact semi-conductrice fortement dopée (16) d'un premier type de conductivité, formée au moins par zones, avec une concentration en dopant d'au moins 1•10¹⁸ cm⁻³ et avec une première constante de réseau,
- une zone d'absorption (12) d'un deuxième type de conductivité avec une concentration en dopant de 8•10¹¹ cm⁻³ - 8•10¹⁴ cm⁻³, une épaisseur de couche (D12) de 80 µm - 2000 µm avec une première bande interdite et avec la première constante de réseau,
- la couche de contact semi-conductrice (16) et la zone d'absorption (12) formée comme couche semi-conductrice comportant chacune au moins un élément du groupe principal III et au moins un élément du groupe principal V,
- une deuxième couche de contact métallique (18) formée au moins par zones,
- la première couche de contact semi-conductrice (16) étant formée comme une structure mesa avec une face inférieure, une face supérieure, une largeur de mesa (B16) et une hauteur de mésa (D16), et la face inférieure de la première couche de contact semi-conductrice (16) étant disposée sur ou au-dessus d'une première partie de surface d'une face supérieure de la zone d'absorption (12) avec une largeur correspondant à la largeur de mésa (B16),
- une face inférieure de la première couche de contact métallique (20) étant reliée par adhésion de matière à la face supérieure de la première couche de contact semi-conductrice (16) et
- la deuxième couche de contact métallique (18) étant disposée en dessous d'une face inférieure de la zone d'absorption (12),
dans laquelle
- le composant photonique semi-conducteur III-V empilé (10) comporte une couche de passivation semi-conductrice III-V (22) avec la première constante de réseau et une deuxième bande interdite différente de la première bande interdite,
- la couche de passivation semi-conductrice III-V (22) présente le premier ou le deuxième type de conductivité et une concentration en dopant de 1•10¹⁴ cm⁻³ - 5•10¹⁸ cm⁻³,
- la couche de passivation semi-conductrice III-V (22) est disposée à une première distance (A1) d'au moins 0,2 µm de la structure mesa de la première couche de contact semi-conductrice sur la face supérieure de la zone d'absorption (12) et est reliée par adhésion de matière à la face supérieure de la zone d'absorption (12).

2. Dispositif photonique semi-conducteur III-V empilé (10) selon la revendication 1, **caractérisé en ce que** la deuxième couche de contact métallique (18) est reliée à la face inférieure de la zone d'absorption (12) ou à une face inférieure d'une couche tampon (32) disposée sous la zone d'absorption (12) ou à une face inférieure d'une couche de substrat disposée sous la zone d'absorption (12).

3. Dispositif photonique à semi-conducteur III-V empilé (10) selon la revendication 1, **caractérisé en ce que** le dispositif photonique semi-conducteur III-V (10) comprend une deuxième couche de contact semi-conductrice (14) fortement dopée, formée au moins par zones, du deuxième type de conductivité avec une concentration en dopant d'au moins 1•10¹⁷ cm⁻³, une épaisseur de couche (D14) d'au plus 100 µm ou d'au plus 50 µm, une face supérieure tournée vers la zone d'absorption (12) et une face inférieure, la deuxième couche de contact semi-conductrice (14) étant disposée en-dessous de la zone d'absorption (12) et la deuxième couche de contact métallique de connexion (18) étant reliée par adhésion de matière à la face inférieure de la deuxième couche de contact semi-conductrice (14).

4. Composant photonique semi-conducteur III-V empilé selon la revendication 3, **caractérisé en ce que** la deuxième couche de contact semi-conductrice (14) présente une épaisseur de couche comprise entre 0,1 µm et 150 µm.

5. Composant photonique semi-conducteur III-V empilable (10) selon la revendication 3 ou 4, **caractérisé en ce que** la deuxième couche de contact semi-conductrice (14) présente la première constante de réseau.

6. Dispositif photonique à semi-conducteur III-V empilable (10) selon la revendication 5, **caractérisé en ce que** la face inférieure de la zone d'absorption (12) est reliée par adhésion de matière à la face supérieure de la deuxième couche de contact semi-conductrice (14).

7. Dispositif photonique semi-conducteur III-V empilé (10) selon la revendication 3 ou 4, **caractérisé en ce que** la deuxième couche de contact semi-conductrice (14) présente une deuxième constante de réseau différente de la première constante de réseau et **en ce qu'**entre la deuxième couche de contact semi-conductrice (14) et la zone d'absorption (12) est disposée une couche tampon (32) ayant la première constante de réseau sur une face supérieure tournée vers la zone d'absorption et la deuxième constante de réseau sur une face inférieure tournée vers la deuxième couche de contact semi-conductrice.

8. Dispositif photonique semi-conducteur III-V empilé (10) selon l'une des revendications 3 à 6, **caractérisé en ce que** la deuxième couche de contact semi-conductrice (14) est réalisée sous forme de couche de substrat ou de couche tampon (32).

9. Dispositif photonique semi-conducteur III-V empilé (10) selon l'une des revendications précédentes, **caractérisé en ce que** la couche de passivation semi-conductrice III-V (22) présente une épaisseur de couche comprise entre 0,02 µm et 1 µm.

10. Composant photonique semi-conducteur III-V empilé (10) selon l'une des revendications précédentes, **caractérisé en ce que** la couche de passivation III-V (22) est constituée d'InGaP ou d'AlGaAs ou d'InGaAsP ou d'InAlP ou d'InAlGaP ou est composée d'InGaP ou d'AlGaAs ou d'InGaAsP ou d'InAlP ou d'InAlGaP.

11. Composant photonique semi-conducteur III-V empilé (10) selon l'une des revendications précédentes, **caractérisé en ce que** la première distance (A1) entre la couche de passivation semi-conductrice III-V (22) et la première couche de contact semi-conductrice (16) est d'au moins 1% de l'épaisseur (D12) de la zone d'absorption (12).

12. Dispositif photonique semi-conducteur III-V empilé selon l'une des revendications précédentes, **caractérisé en ce que** la couche de passivation semi-conductrice III-V (22) entoure complètement la première couche de contact semi-conductrice (16) dans une projection perpendiculaire à la face supérieure de la première couche de contact semi-conductrice (12).

13. Dispositif photonique à semi-conducteur III-V empilé (10) selon l'une des revendications précédentes, **caractérisé en ce que** le dispositif semi-conducteur III-V comporte une autre couche de passivation (30), l'autre couche de passivation (30) recouvrant au moins une face supérieure de la couche de passivation semi-conductrice III-V (22), une surface latérale de la couche de passivation semi-conductrice III-V (22) tournée vers la structure mesa et une partie d'une face supérieure de la zone d'absorption (12) adjacente à la surface latérale de la couche de passivation semi-conductrice III-V (22).

14. Dispositif photonique semi-conducteur III-V empilé (10) selon la revendication 13, **caractérisé en ce que** la couche de passivation supplémentaire (30) comprend du Si₃N₄ et/ou du SiO₂ et/ou du SiNOₓ et/ou du polyimide ou est constituée de Si₃N₄ et/ou de SiO₂ et/ou de SiNOₓ et/ou de polyimide.

15. Dispositif photonique semi-conducteur III-V empilé (10) selon l'une des revendications précédentes, **caractérisé en ce que** la première couche de contact semi-conductrice (16) et/ou la zone d'absorption (12) et/ou la couche de passivation semi-conductrice III-V (22) sont chacune produites par épitaxie sur une couche précédente du composant photonique semi-conducteur III-V (10).

16. Composant photonique semi-conducteur III-V empilé (10) selon l'une des revendications précédentes, **caractérisé en ce que** la deuxième couche de contact métallique (18) présente une épaisseur de couche de 5 µm à 2 µm.

17. Composant photonique semi-conducteur III-V empilé (10) selon l'une des revendications précédentes, **caractérisé en ce que** la deuxième couche de contact métallique (18) est réalisée sous forme ponctuelle, plane ou en forme de doigts.

18. Composant photonique semi-conducteur III-V empilé (10) selon l'une des revendications précédentes, **caractérisé en ce que** la première couche de contact semi-conductrice (16) et la zone d'absorption (12) comportent chacune du GaAs ou sont constituées chacune de GaAs.

19. Composant photonique semi-conducteur III-V empilé (10) selon l'une des revendications précédentes, **caractérisé en ce que** la face supérieure de la première couche de contact semi-conductrice (16) présente un contour circulaire, ovale ou polygonal.

20. Dispositif photonique semi-conducteur III-V empilé (10) selon la revendication 1, **caractérisé en ce que** le dispositif photonique semi-conducteur III-V empilé (10) comporte une couche tampon (32), la couche tampon (32) étant disposée en dessous de la face inférieure de la zone d'absorption (12) et au-dessus de la deuxième couche de contact métallique (18) et présente, sur une face supérieure tournée vers la zone d'absorption, la première constante de réseau et, sur une face inférieure tournée vers la deuxième couche de contact métallique (18), une deuxième constante de réseau différente de la première constante de réseau.

21. Composant photonique semi-conducteur III-V empilé (10) selon l'une des revendications précédentes, **caractérisé en ce que** le composant photonique semi-conducteur III-V empilé (10) présente une couche intermédiaire semi-conductrice (24) formée au moins par zones avec une concentration en dopant de 1•10¹⁴ cm⁻³ - 1•10¹⁶ cm⁻³ et une épaisseur de couche (D24) d'au plus 50 µm, la couche intermédiaire semi-conductrice (24) étant disposée au-dessus de la zone d'absorption (12) et au-dessous de la première couche de contact semi-conductrice (16) et présentant le premier type de conductivité et la première constante de réseau et/ou la couche intermédiaire semi-conductrice (24) étant disposée au-dessous de la zone d'absorption (12) et au-dessus d'une deuxième couche de contact semi-conductrice (14) et présente le deuxième type de conductivité et une constante de réseau correspondant à l'une des constantes de réseau de la deuxième couche de contact semi-conductrice (14).

22. Dispositif photonique semi-conducteur III-V empilé (10) selon l'une des revendications 1 ou 2, **caractérisé en ce que** la deuxième bande interdite de la couche de passivation semi-conductrice III-V (22) est supérieure à la première bande interdite de la zone d'absorption (12).
